# EUROPEAN PATENT SPECIFICATION

(11) **EP 3 343 656 B1**
(45) Date of publication and mention of the grant of the patent: **08.12.2021**
(21) Application number: 17209844.4
(22) Date of filing: 21.12.2017
(51) Int. Cl.: H01L 51/00, H01L 51/42

(54) **PHOTOELECTRIC CONVERSION ELEMENT**
ELEMENT ZUR PHOTOELEKTRISCHEN UMWANDLUNG
ÉLÉMENT DE CONVERSION PHOTOÉLECTRIQUE

(30) Priority: 27.12.2016 JP 2016254294
(43) Date of publication of application: 04.07.2018
(73) Proprietor: Ricoh Company, Ltd., Tokyo 143-8555 (JP)
(72) Inventor: ARAI, Ryota, Ohta-ku, Tokyo 143-8555 (JP)
(74) Representative: Fairbairn, Angus Chisholm

(56) References cited:
- CN-A- 103 788 111
- JP-A- 2016 175 868
- Yoshihide Santo ET AL: "Mixture of [60] and [70]PCBM giving morphological stability in organic solar cells", Applied Physics Letters, 12 August 2013 (2013-08-12), page 73306, XP055466996, DOI: 10.1063/1.4818726 Retrieved from the Internet: URL:https://aip.scitation.org/doi/pdf/10.1 063/1.4818726 [retrieved on 2018-04-13]

## Description

### BACKGROUND OF THE INVENTION

### Field of the Invention

The present disclosure relates to a photoelectric conversion element.

### Description of the Related Art

In recent years, the power for driving electric circuits has become extremely low. Preparing for the coming IoT society, various electronic parts, such as sensors, have been able to be driven with very low electric power (order of µW). As utilization of sensors, moreover, applications of the sensors for energy harvesting elements have been expected as self-sufficient energy supplies capable of generating and consuming power in-situ. Among the energy harvesting elements, photoelectric conversion elements have been attracted attentions as elements capable of generating power anywhere as long as there is light. There are needs for photoelectric conversion elements that can efficiently generate power even with very weak light.

Typical examples of very weak light include light emitted from LED (light emitting diodes or luminous diode) lamps and light emitted from fluorescent lamps. These types of light is particularly called indoor light because it is mainly used indoor. Illuminance of indoor light is from about 20 Lux to about 1,000 Lux and the indoor light is extremely weak light compared to direct sun light (about 100,000 Lux). As energy-harvesting element, desired is an element capable of efficiently generating power particularly with indoor light from fluorescent lamps or LED lamps.

As the photoelectric conversion element, silicon-based solar cells have been most widely distributed, and number of silicon-based solar cells having high conversion efficiency with sun light have been reported. The conversion efficiency of the silicon-based solar cells is excellent with sun light, but it is generally known that the silicon-based solar cells have low conversion efficiency with very weak light (see, for example, Nature, 353 (1991) 737). Moreover, it has been known that a bulk heterojunction organic-thin-film solar cell developed by Heeger et al. has relatively high power-generation capability with very weak light. In the bulk heterojunction organic-thin-film solar cell, a P-type organic semiconductor and an N-type organic semiconductor such as fullerene are mixed (see, for example, Applied physics letters 108, 253301 (2016)).

As a P-type material for use in an organic-thin-film solar cell, moreover, there are number of reports on use of polymers. In recent years, use of a low-molecular P-type material has been also reported, and such a low-molecular P-type material has reported to have more excellent properties with very weak light than polymers. Therefore, more detailed researches have been performed on low-molecular P-type materials.

Meanwhile, PCBM that is a fullerene derivative is mainly used as an N-type material in an organic-thin-film solar cell using a polymer material. PCBM is also often used in an organic-thin-film solar cell having a low-molecular P-type material. As PCBM, PC61BM (phenyl C61 methyl butyrate) or PC71BM (phenyl C71 methyl butyrate) is typically studied. In terms of power generation under artificial sunlight, PC71BM is excellent in terms of absorption wavelengths.

The present disclosure has an object to provide a photoelectric conversion element having high conversion efficiency even with very weak light, such as light from LED.

The document CN 103 788 111 A discloses a photoelectric conversion element comprising a conversion layer comprising a mixture of a N-type C60 or C70 fullerene derivative compound and a P-type material.

### SUMMARY OF THE INVENTION

According to one aspect of the present disclosure, a photoelectric conversion element includes a first electrode, an electron-transporting layer, a photoelectric conversion layer, a hole-transporting layer, and a second electrode. The electron-transporting layer, the photoelectric conversion layer, the hole-transporting layer, and the second electrode are sequentially disposed on the first electrode. The photoelectric conversion layer includes a mixture of a P-type material and an N-type material. The P-type material is a compound represented by General Formula 1 below. The N-type material includes a mixture of C70 Fullerene Derivative A having a substituent represented by General Formula 2 below and C60 Fullerene Derivative B having a substituent identical to the substituent of C70 Fullerene Derivative A, and a mixing mass ratio (A:B) of C70 Fullerene Derivative A to C60 Fullerene Derivative B is from 5:95 through 30:70.

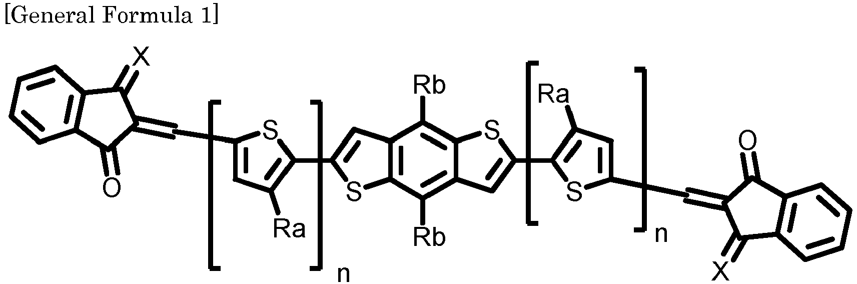

In General Formula 1, n is an integer of from 1 through 3, Ra is an alkyl group having 4 through 12 carbon atoms, Rb is an oxygen atom including an alkyl group having 6 through 22 carbon atoms, a sulfur atom including an alkyl group having 6 through 22 carbon atoms, a carbon atom including an alkyl group having 6 through 22 carbon atoms, or a group represented by General Formula 5 below, and X is an oxygen atom or a dicyanomethylene group.

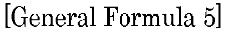

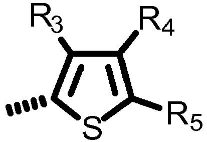

In General Formula 5, R₃ and R₄ are each a hydrogen atom or an alkyl group having 6 through 12 carbon atoms, and R₅ is an alkyl group that has 6 through 22 carbon atoms and may be branched.

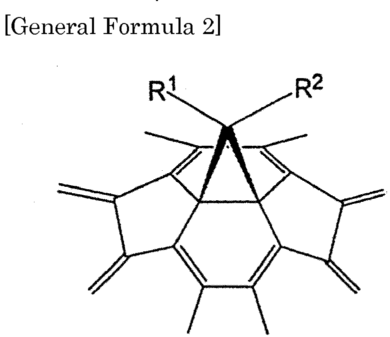

General Formula 2 represents a partial structure of a fullerene skeleton, and in General Formula 2, R¹ and R² are each independently an alkyl group, an alkyl group having a substituent, an aryl group, an aryl group having a substituent, or an alkoxycarbonyl group.

The present disclosure can provide a photoelectric conversion element having high conversion efficiency with very weak light such as light from LED.

### BRIEF DESCRIPTION OF THE DRAWINGS

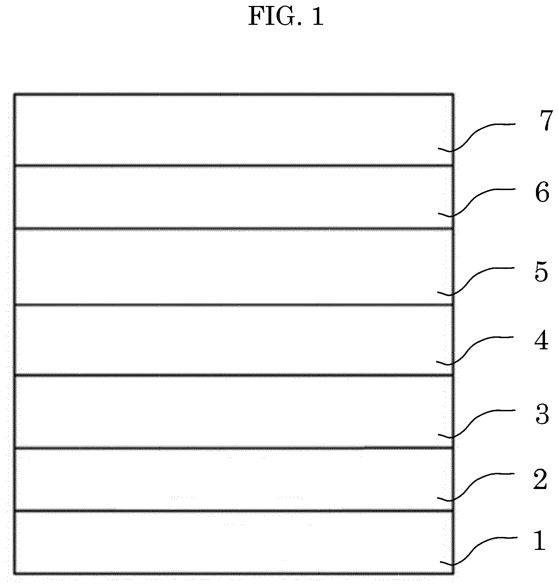

FIG. 1 is a schematic view illustrating one example of a layer structure of a photoelectric conversion element of the present disclosure.

### DESCRIPTION OF THE EMBODIMENTS

### (Photoelectric conversion element)

A photoelectric conversion element of the present disclosure includes a first electrode, an electron-transporting layer, a photoelectric conversion layer, a hole-transporting layer, and a second electrode. The electron-transporting layer, the photoelectric conversion layer, the hole-transporting layer and the second electrode are sequentially disposed on the first electrode. The photoelectric conversion layer includes a mixture of a P-type material and an N-type material. The P-type material is a compound represented by General Formula 1 below. The N-type material is a mixture of C70 Fullerene Derivative A having a substituent represented by General Formula 2 below and C60 Fullerene Derivative B having a substituent identical to the substituent of C70 Fullerene Derivative A, and a mixing mass ratio (A:B) of C70 Fullerene Derivative A to C60 Fullerene Derivative B is from 5:95 through 30:70. The photoelectric conversion element of the present disclosure may further include other members according to the necessity.

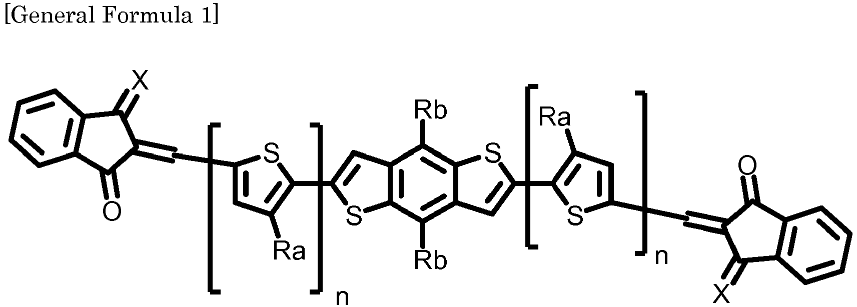

In General Formula 1, n is an integer of from 1 through 3, Ra is an alkyl group having 4 through 12 carbon atoms, Rb is an oxygen atom including an alkyl group having 6 through 22 carbon atoms, a sulfur atom including an alkyl group having 6 through 22 carbon atoms, a carbon atom including an alkyl group having 6 through 22 carbon atoms, or a group represented by General Formula 5 below, and X is an oxygen atom or a dicyanomethylene group.

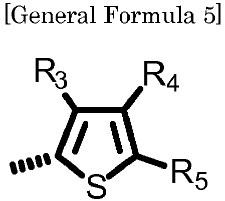

In General Formula 5, R₃ and R₄ are each a hydrogen atom or an alkyl group having 6 through 12 carbon atoms, and R₅ is an alkyl group that has 6 through 22 carbon atoms and may be branched.

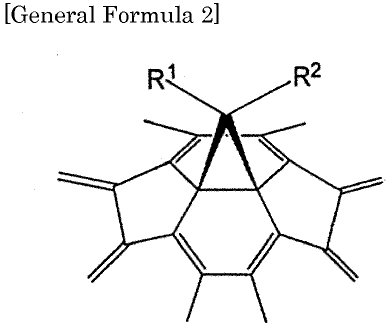

General Formula 2 represents a partial structure of a fullerene skeleton, and in General Formula 2, R¹ and R² are each independently an alkyl group, an alkyl group having a substituent, an aryl group, an aryl group having a substituent, or an alkoxycarbonyl group.

The photoelectric conversion element of the present disclosure has accomplished based on the following insight. With a known organic-thin-film solar cell using a polymer material, there is no significant difference in power generation with very weak light such as light from LED whether an N-type material for use is PC61BM or PC71BM. Therefore, further improvement in power generation of the organic-thin-film solar cell using a polymer material is desired.

In the present disclosure, the term "photoelectric conversion element" means an element which converts optical energy into electric energy, or an element which converts electric energy into optical energy. Specific examples of the photoelectric conversion element include solar cells and photo diodes.

### <Substrate>

The substrate is not particularly limited and may be appropriately selected from substrates known in the art.

The substrate is preferably formed of a transparent material. Examples of the transparent material include glass, transparent plastic plates, transparent plastic films, and transparent inorganic crystals.

### <First electrode and second electrode>

As long as at least one of the first electrode and the second electrode is an electrode transparent to visible light, the other electrode may be transparent or not transparent to visible light.

The electrode transparent to visible light is not particularly limited, and known electrodes used for typical photoelectric conversion elements, liquid crystal panels etc., can be used. Examples of the electrode transparent to visible light include conductive metal oxides, such as tin-doped indium oxide (referred to as "ITO" hereinafter), fluorine-doped tin oxide (referred to as "FTO" hereinafter), antimony-doped tin oxide (referred to as "ATO" hereinafter), and aluminium- or gallium-doped zinc oxide (referred respectively as "AZO," and "GZO" hereinafter).

An average thickness of the electrode transparent to visible light is preferably 5 nm or greater but 10 µm or less, and more preferably 50 nm or greater but 1 µm or less.

In order to secure certain hardness, the electrode transparent to visible light is preferably disposed on a substrate formed of a material transparent to visible light. A product where the electrode and the substrate are integrated can also be used. Examples of the integrated product include FTO coated glass, ITO coated glass, zinc oxide-aluminium coated glass, FTO-coated transparent plastic films, and ITO-coated transparent plastic films.

The electrode transparent to visible light may be an electrode containing a substrate (e.g., a glass substrate) on which a metal electrode having the structure through which light can pass (e.g., a mesh-patterned structure or a stripe-pattered structure) is disposed. Alternatively, the electrode transparent to visible light may be an electrode where carbon nanotube or graphene is disposed on the substrate in a manner that transparency is secured. These may be used alone, or in combination, or in the state of a laminate.

In order to reduce substrate resistance, moreover, a metal lead wire may be used. Examples of a material of the metal lead wire include metals, such as aluminium, copper, silver, gold, platinum, and nickel. The metal lead wire is disposed on the substrate, for example, by vapor deposition, sputtering, or crimping, followed by disposing ITO or FTO on the metal.

In the case where an opaque electrode is used for one of the first electrode and the second electrode, examples of the opaque electrode include: metals, such as platinum, gold, silver, copper, and aluminium (Al); and graphite. The above-listed examples may be used alone or in combination.

An average thickness of the opaque electrode is not particularly limited and may be appropriately selected depending on the intended purpose.

### <Electron-transporting layer>

The electron-transporting layer is disposed between the first electrode and the photoelectric conversion layer and has a function of blocking holes as well as transporting electrons.

A material for forming the electron-transporting material is not particularly limited and may be appropriately selected depending on the intended purpose. Examples of the electron-transporting layer include electron-accepting organic materials (e.g., perylenetetracarboxylic anhydride, perylenetetracarboxylic diimide, oxazole derivatives, triazol derivatives, phenanthroline derivatives, phosphine oxide derivatives, fullerene compounds, carbon nanotubes (CNT), and CN-PPV) and inorganic materials (e.g., zinc oxide, titanium oxide, lithium fluoride, and calcium metal). The above-listed examples may be used alone or in combination.

Examples of a production method of the electron-transporting layer include coating, a sol-gel method, and sputtering. Among the above-listed examples, coating is preferable. Examples of the coating include spin coating, blade coating, slit-die coating, screen printing, bar-coater coating, mold coating, transfer printing, dip coating, and inkjet coating.

An average thickness of the electron-transporting layer is not particularly limited and may be appropriately selected depending on the intended purpose. The electron-transporting layer preferably thinly covers the entire surface, and more preferably, the average thickness of the electron-transporting layer is 10 nm or greater but 100 nm or less.

### <Photoelectric conversion layer>

The photoelectric conversion layer includes a mixture of a P-type material and an N-type material.

A mixing mass ratio (P:N) of the P-type material to the N-type material is preferably from 40:60 through 80:20, more preferably from 50:50 through 80:20, and even more preferably from 65:35 through 80:20. When the mixing mass ratio (P:N) is within the above-mentioned range, a high-performance photoelectric conversion element targeted by the present disclosure can be obtained.

### -P-type material-

As the P-type material, a compound represented by General Formula 1 below is used.

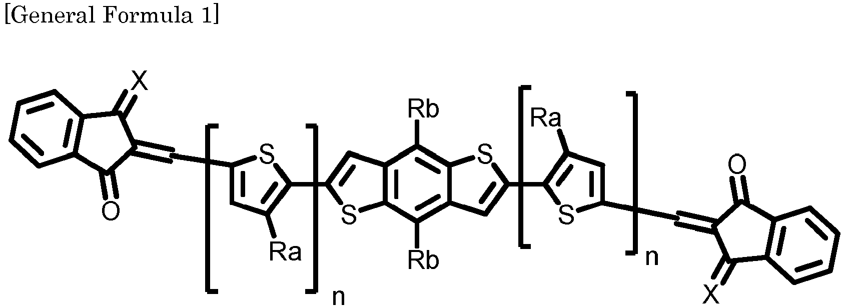

In General Formula 1, n is an integer of 1 through 3; Ra is an alkyl group having 4 through 12 carbon atoms; Rb is an oxygen atom including an alkyl group having 6 through 22 carbon atoms, a sulfur atom including an alkyl group having 6 through 22 carbon atoms, a carbon atom including an alkyl group having 6 through 22 carbon atoms, or a group represented by General Formula 5 below, and Rb is preferably an oxygen atom including an alkyl group having 6 through 20 carbon atoms, a sulfur atom including an alkyl group having 6 through 20 carbon atoms, a carbon atom including an alkyl group having 6 through 20 carbon atoms, or a group represented by General Formula 5 below; and X is an oxygen atom or a dicyanomethylene group.

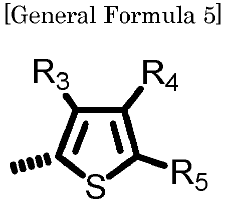

In General Formula 5, R₃ and R₄ are each a hydrogen atom or an alkyl group having 6 through 12 carbon atoms and preferably an alkyl group having 6 through 10 carbon atoms, and R₅ is an alkyl group that has 6 through 22 carbon atoms and may be branched and preferably an alkyl group that has 6 through 12 carbon atoms and may be branched.

The compound represented by General Formula 1 is preferably a compound represented by General Formula 3 below, a compound represented by General Formula 4 below, a compound represented by General Formula 6 below, or a compound represented by General Formula 7 below.

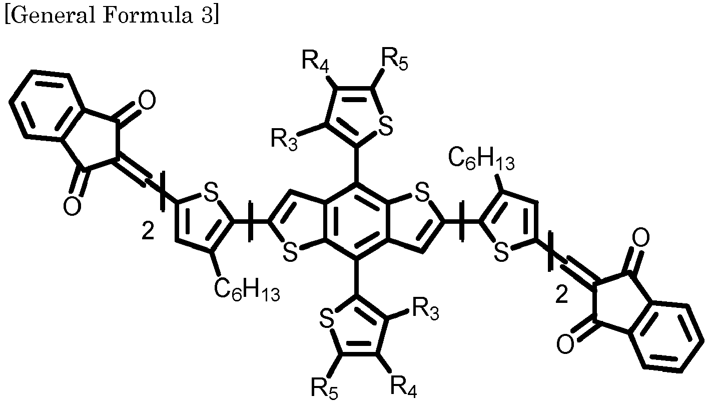

In General Formula 3, R₃ and R₄ are each a hydrogen atom or an alkyl group having 6 through 12 carbon atoms and preferably an alkyl group having 6 through 10 carbon atoms, and R₅ is an alkyl group that has 6 through 22 carbon atoms and may be branched and preferably an alkyl group that has 6 through 12 carbon atoms and may be branched.

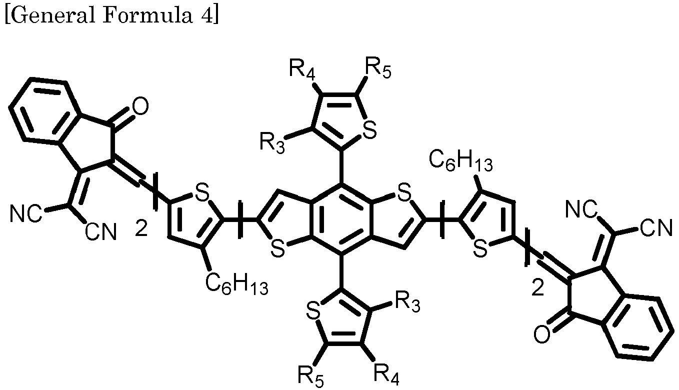

In General Formula 4, R₃ and R₄ are each a hydrogen atom or an alkyl group having 6 through 12 carbon atoms and preferably an alkyl group having 6 through 10 carbon atoms, and R₅ is an alkyl group that has 6 through 22 carbon atoms and may be branched and preferably an alkyl group that has 6 through 12 carbon atoms and may be branched.

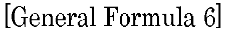

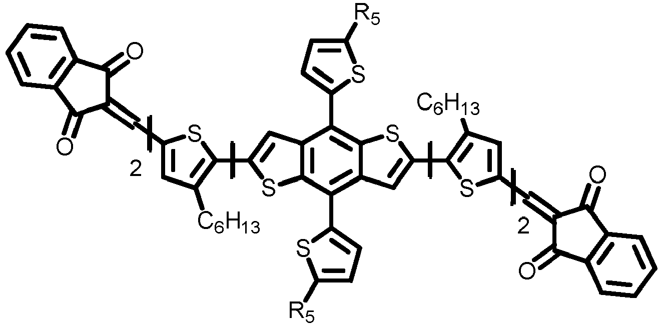

In General Formula 6, R₅ is an alkyl group that has 6 through 22 carbon atoms and may be branched, and is preferably an alkyl group that has 6 through 12 carbon atoms and may be branched.

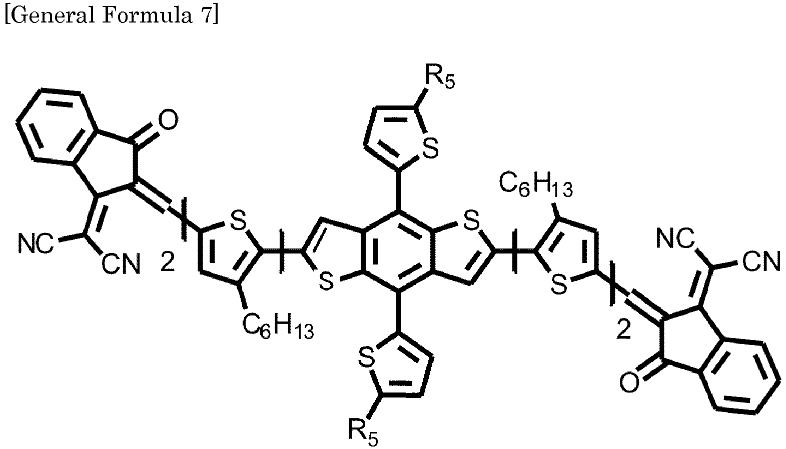

In General Formula 7, R₅ is an alkyl group that has 6 through 22 carbon atoms and may be branched, and preferably an alkyl group that has 6 through 12 carbon atoms and may be branched.

Specific examples of the P-type material represented by General Formula (1) include compounds represented by structural formulae below, but the P-type material for use in the present disclosure is not limited to the examples listed below.

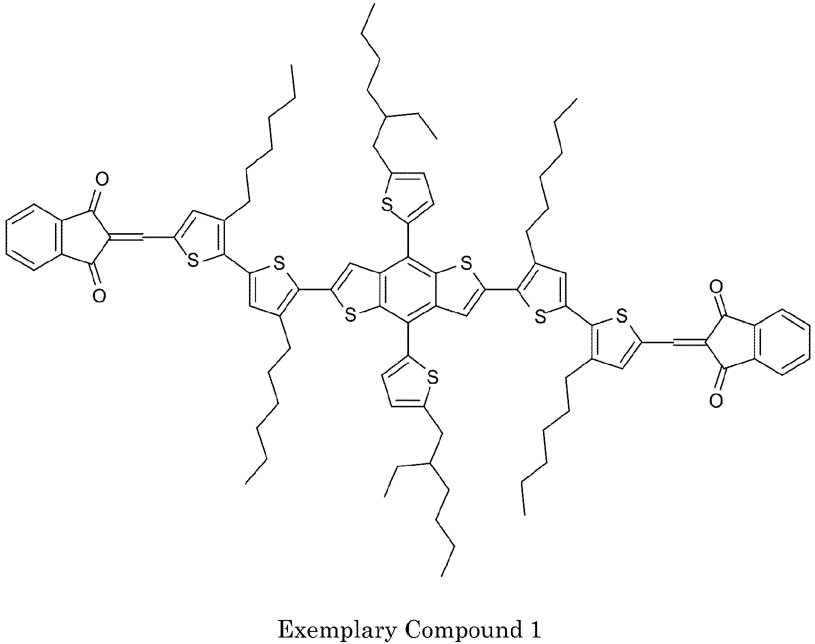

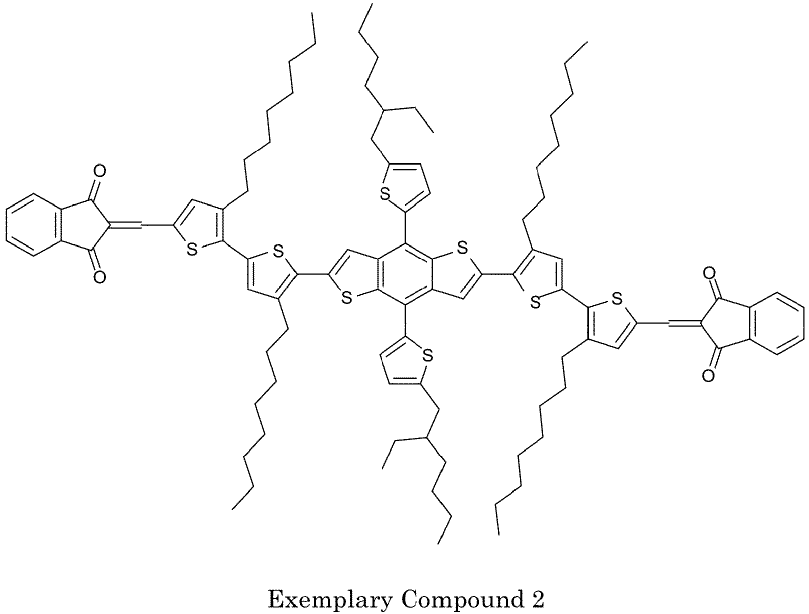

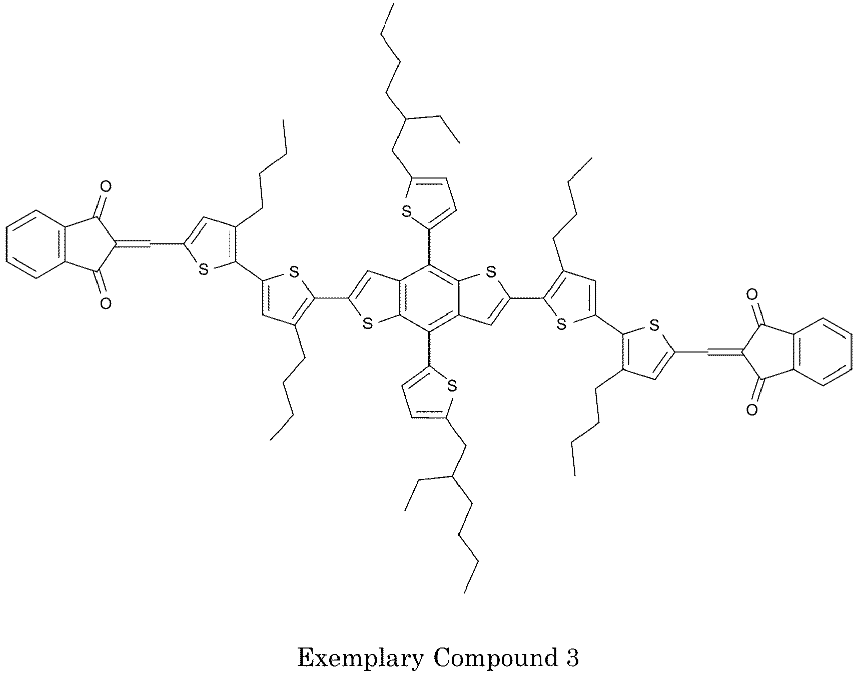

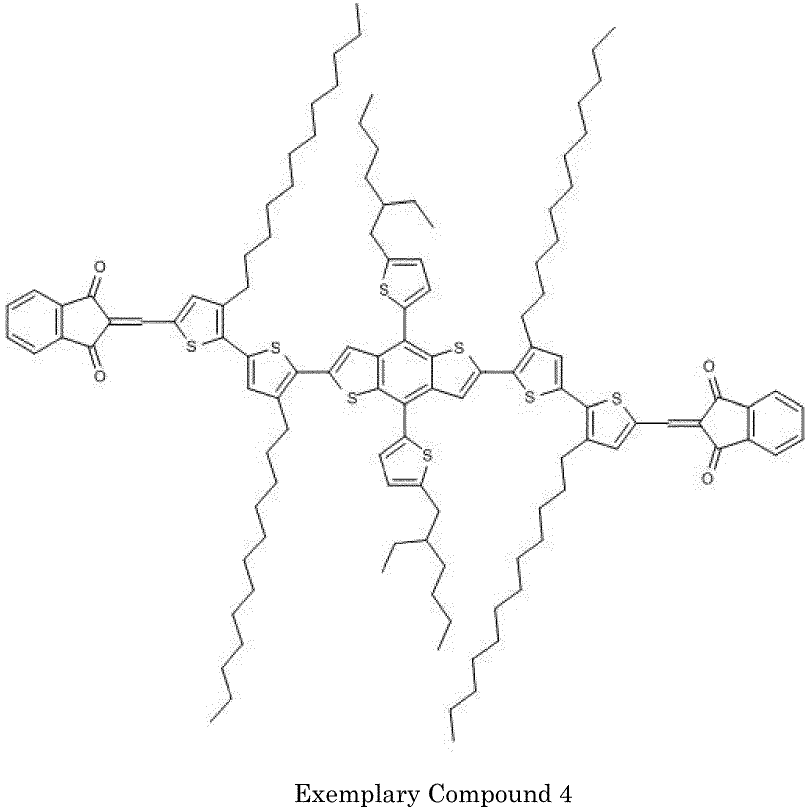

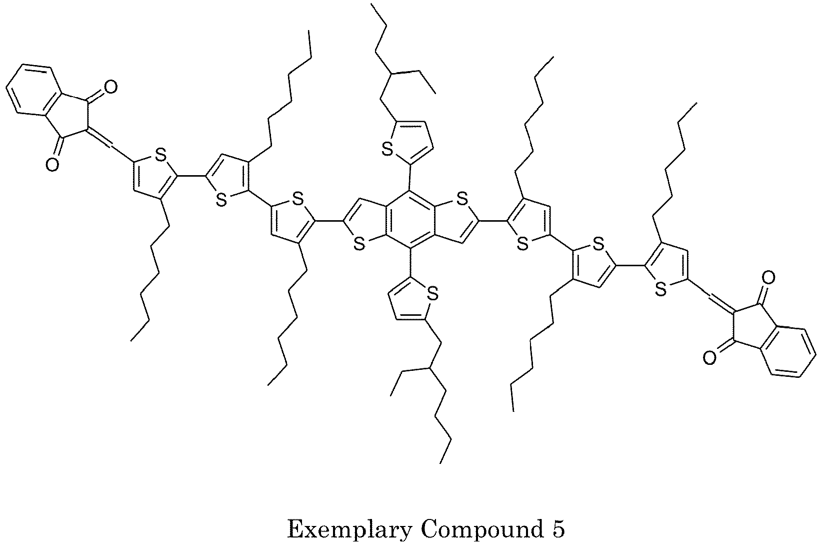

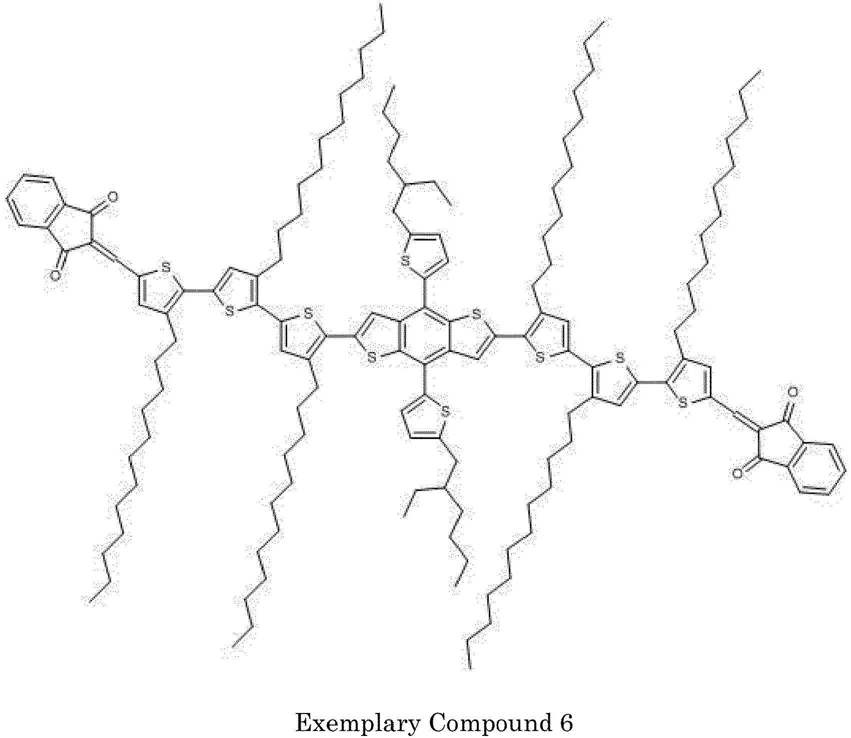

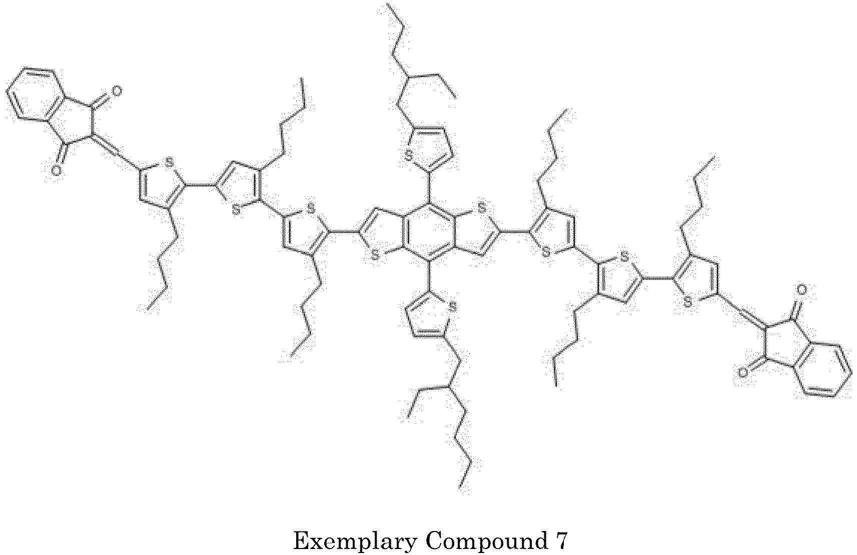

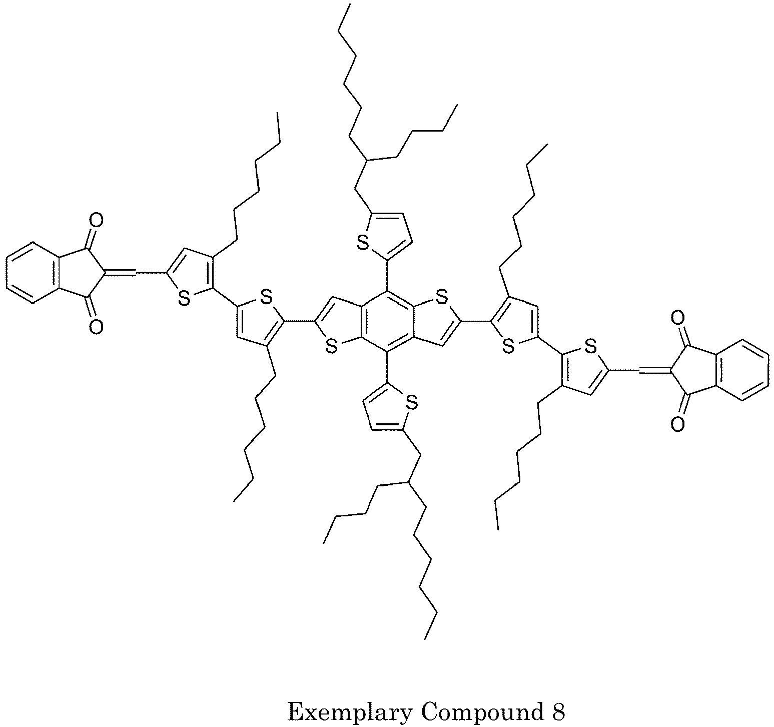

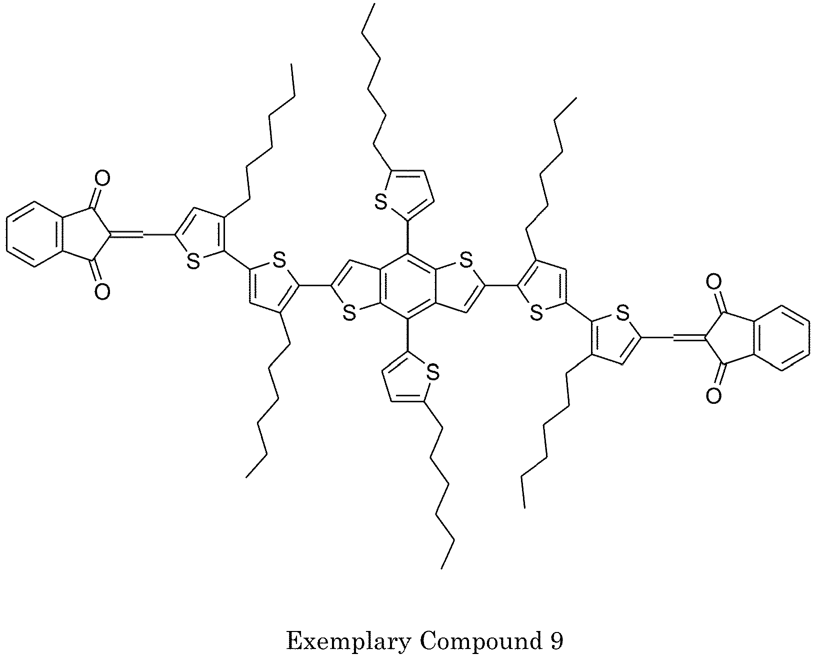

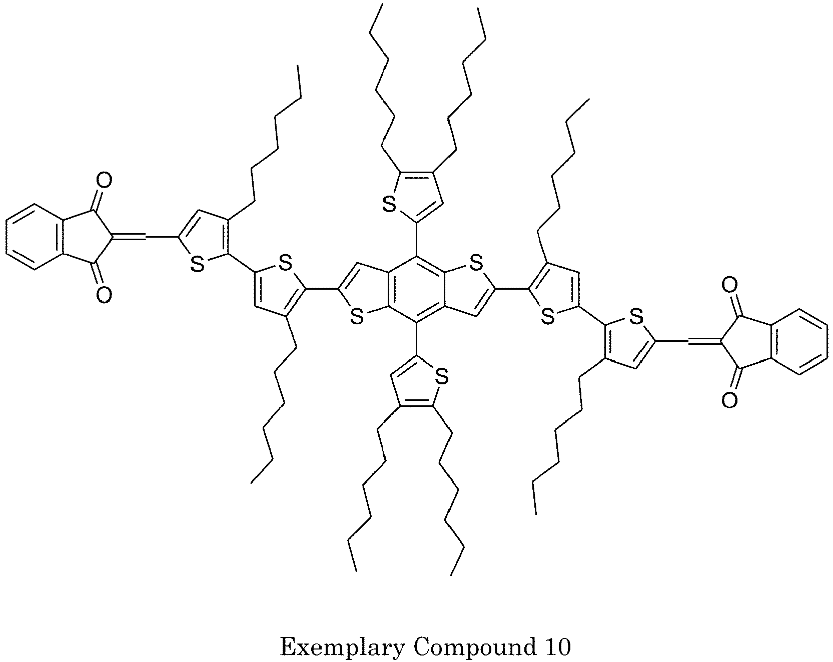

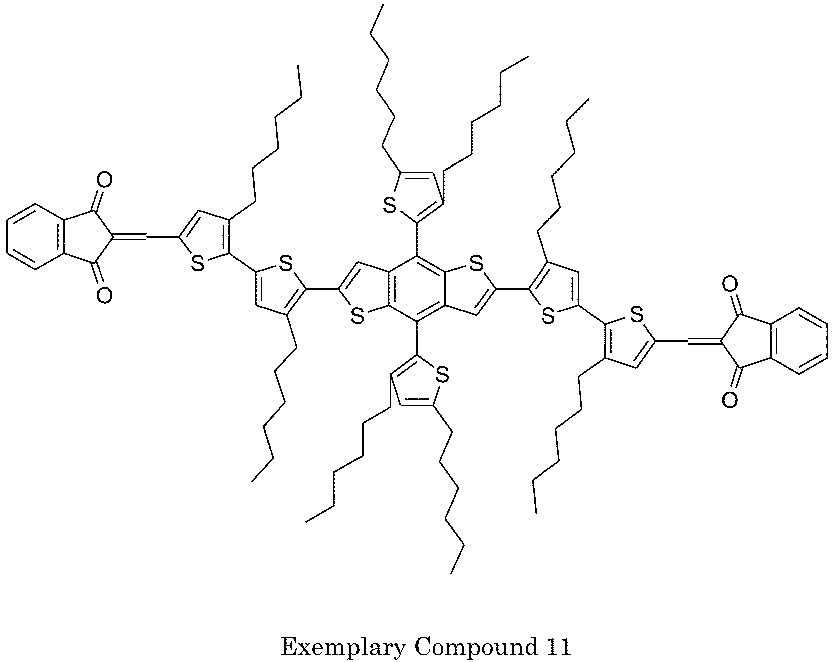

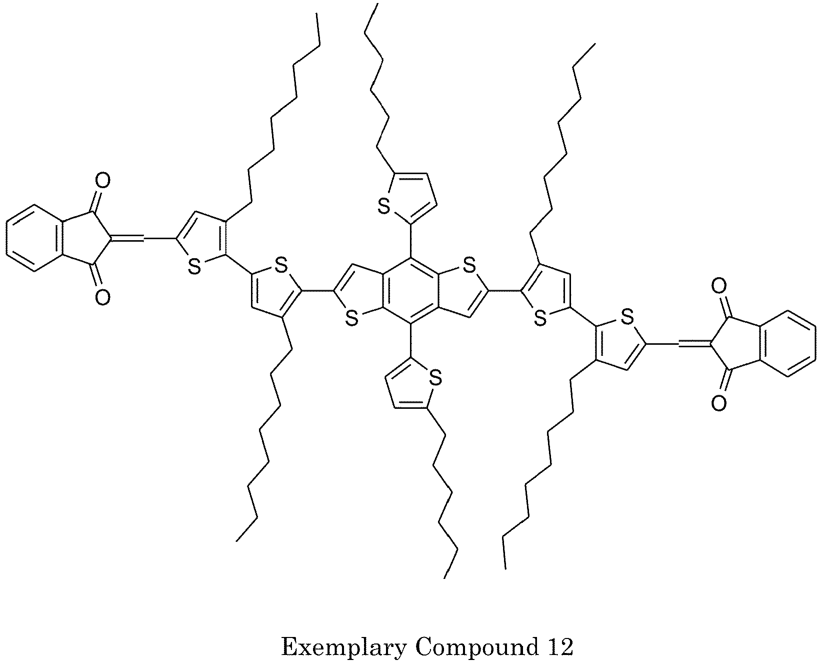

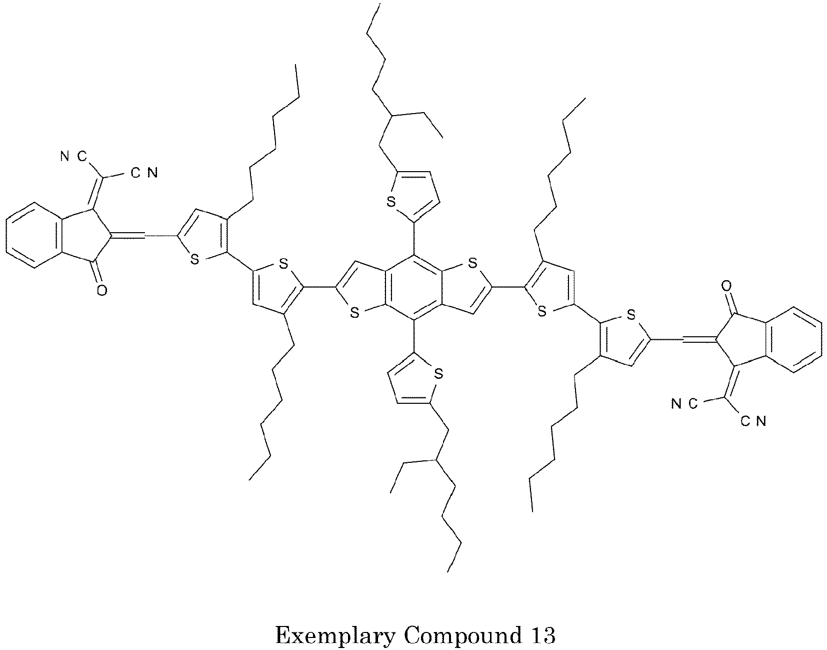

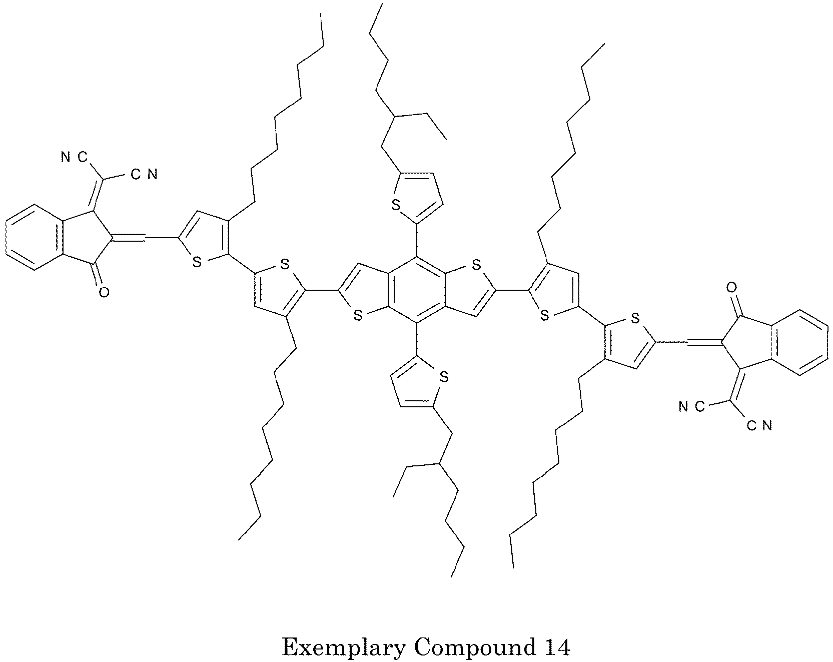

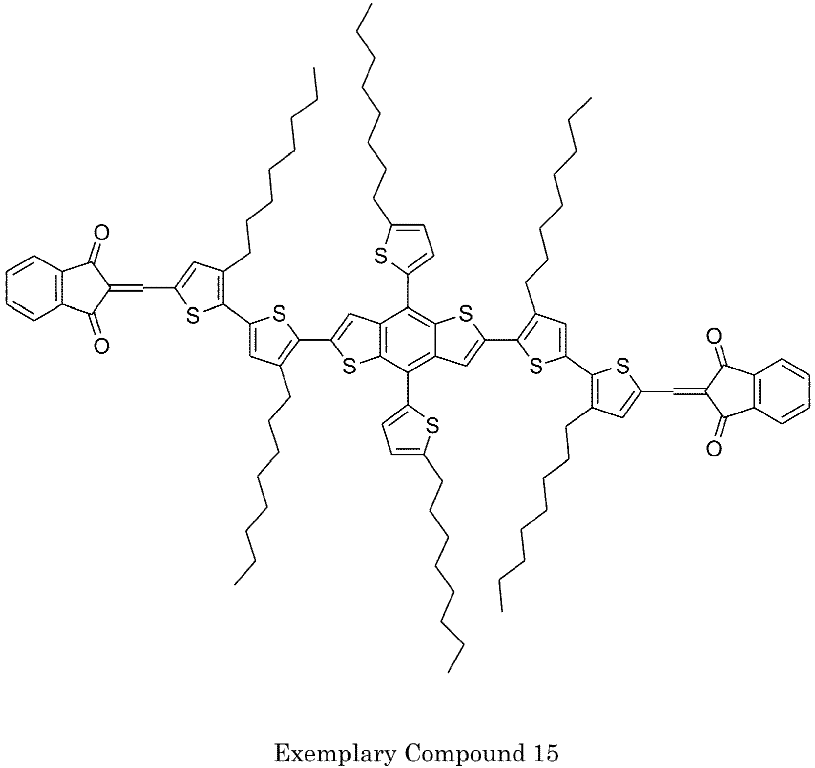

### -N-type material-

The N-type material includes a mixture of C70 Fullerene Derivative A having a substituent represented by General Formula 2 below and C60 Fullerene Derivative B having a substituent identical to the substituent of C70 Fullerene Derivative A.

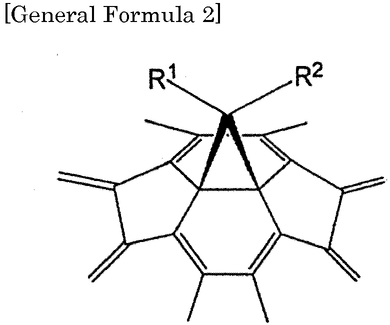

General Formula 2 represents a partial structure of a fullerene skeleton, and in General Formula 2, R¹ and R² are each independently an alkyl group, an alkyl group having a substituent, an aryl group, an aryl group having a substituent, or an alkoxycarbonyl group.

The term "fullerene" means a spherical shell or substantially spherical shell molecule composed only of carbon and having a hollow closed-shell structure. The number of carbons constituting the closed-shell structure is typically an even number of from 60 through 130.

Specific examples of the fullerene include spherical shell or substantially spherical shell molecules of C60, C70, C76, C78, C82, C84, C90, C94, and C96, and spherical shell or substantially spherical shell molecules having the larger number of carbons than C96.

The term "fullerene structure" means a spherical shell structure or substantially spherical shell structure composed of carbons and having a hollow closed-shell structure. In the present disclosure, only cases of C60 fullerene and C70 fullerene are explained. However, cases where other fullerenes are used or contained are naturally included in the present disclosure. Moreover, part of carbons constituting the spherical shell or substantially spherical shell molecule, and the spherical shell structure or substantially spherical shell structure may be lost.

In General Formula 2, R¹ and R² are each independently an alkyl group, an alkyl group having a substituent, an aryl group, an aryl group having a substituent, or an alkoxycarbonyl group.

The alkyl group is not particularly limited and may be appropriately selected depending on the intended purpose. The alkyl group is preferably an alkyl group having 1 through 12 carbon atoms and more preferably an alkyl group having 1 through 6 carbon atoms.

The aryl group is not particularly limited and may be appropriately selected depending on the intended purpose. The aryl group is preferably an aryl group having 6 through 12 carbon atoms.

An alkoxy group of the alkoxycarbonyl group is preferably an alkoxy group having 1 through 12 carbon atoms.

Examples of a substituent of the alkyl group and a substituent the aryl group include: halogen atoms, such as fluorine, chloride, bromine, and iodine; atoms, such as oxygen, nitrogen, sulfur, and silicon; aromatic ring groups, such as a phenyl group, a tolyl group, a naphthyl group, and a pyridyl group; alkoxy groups, such as a methoxy group, an ethoxy group, and a propoxy group; groups, such as a hydroxyl group, a mercapto group, a sulfone group, a sulfonyl group, a phosphoric acid group, carboxyl group, an alkoxycarbonyl group, an alkoxy group, an aldehyde group, an acyl group, an imide group, a nitro group, an amino group, an amide group, a nitrile group, an alkylsilyl group, and a phosphine group; alkenyl groups, such as a vinyl group and an allyl group; and alkynyl groups, such as an ethynyl group and a propargyl group. The above-listed examples may be used alone or in combination.

Among the above-listed examples, an alkoxy group and an alkoxycarbonyl group are preferable.

The alkoxy group and an alkoxy group of the alkoxycarbonyl group are each preferably an alkoxy group that has 1 through 20 carbon atoms and may be a straight chain, a branched chain, or may form a ring.

R¹ is preferably an aryl group or an aryl group having a substituent, and more preferably an aryl group.

R² is preferably an alkyl group or an alkyl group having a substituent, more preferably an alkyl group having a substituent, and even more preferably an alkyl group substituted with an alkoxycarbonyl group.

A mixing mass ratio (A:B) of Fullerene Derivative A to Fullerene Derivative B is from 5:95 through 30:70 and preferably from 15:85 through 25:75.

When the mixing mass ratio (A:B) is from 5:95 through 30:70, a photoelectric conversion element having high conversion efficiency with very weak light, such as light from LED, can be provided.

In the present disclosure, the P-type material and the N-type material may form a planar junction interface. It is however preferable that the P-type material and the N-type material form a bulk heterojunction where the P-type material and the N-type material be three-dimensionally mixed, in order to increase a junction interface area.

In the case where materials having high solubility are used, the bulk heterojunction can be formed by dissolving a P-type material and an N-type material in a solvent to prepare a solution in which the P-type material and the N-type material are mixed in the molecular state, and applying the solution, followed by drying to remove the solvent. Moreover, a heating treatment may be performed to optimize an aggregation state of each of the semiconductors.

In the case where materials having poor solubility are used, a mixture layer can be also formed by dispersing the N-type material in a solvent in which the P-type material has been dissolved to prepare a solution, and applying the solution. In this case, a heating treatment may be further performed to optimize an aggregation state of each of the materials.

Examples of a formation method of the P-type material thin film include spin coating, blade coating, slit-die coating, screen printing, bar-coater coating, mold coating, transfer printing, dip coating, inkjet coating, spraying, and vacuum vapor deposition. The formation method may be appropriately selected from the above-listed examples depending on properties of an organic material thin film to be produced, such as a thickness and orientation.

In the case where spin coating is performed, for example, a concentration of the P-type material having a structure represented by General Formula 1 and a N-type material (a mass of the P-type material having a structure represented by General Formula 1 and the N-type material relative to a volume of a solution including the P-type material having a structure represented by General Formula 1, the N-type material, and a solvent) is preferably from 5 mg/mL through 50 mg/mL. By adjusting the concentration to the above-mentioned range, a uniform photoelectric conversion layer can be easily produced.

Annealing may be performed on the produced photoelectric conversion layer under reduced pressure or in an inert atmosphere (nitrogen or argon atmosphere) in order to remove the organic solvent. A temperature of the annealing is preferably 40°C through 300°C, more preferably from 50°C through 150°C. By performing the annealing, moreover, short-circuit current may be increased because the stacked layers penetrate into each other at an interface to increase a contact effective area. Note that, the annealing may be performed after forming electrodes.

An average thickness of the photoelectric conversion layer is preferably 50 nm or greater but 400 nm or less, and more preferably 60 nm or greater but 250 nm or less. When the average thickness is 50 nm or greater, insufficient generation of carriers due to low light absorption by the photoelectric conversion layer can be prevented. When the average thickness is 400 nm or less, reduction in transfer efficiency of carriers generated by light absorption can be prevented.

### <Hole-transporting layer>

Hole collection efficiency can be improved by disposing the hole-transporting layer on the photoelectric conversion layer.

Examples of a material of the hole-transporting layer include: conductive polymers, such as polyethylenedioxythiophene-polystyrene sulfonate (PEDOT:PSS); hole-transporting organic compounds, such as aromatic amine derivatives; and hole-transporting inorganic compounds, such as molybdenum oxide, vanadium oxide, and nickel oxide. Among the above-listed example, molybdenum oxide is preferable.

The hole-transporting layer is formed by spin coating, performing a sol-gel method, or sputtering a hole-transporting organic compound such as a conductive polymer (e.g., polyethylenedioxythiophene-polystyrene sulfonate [PEDOT:PSS]) or a hole-transporting inorganic compound, such as molybdenum oxide, vanadium oxide, and nickel oxide.

It is preferable that the hole-transporting layer cover thinly the entire surface of the photoelectric conversion layer as much as possible. An average thickness of the hole-transporting layer is not particularly limited and may be appropriately selected depending on the intended purpose. The average thickness is preferably 1 nm or greater but 50 nm or less.

### <Other members>

The above-mentioned other members are not particularly limited and may be appropriately selected depending on the intended purpose. Examples of the members include a gas-barrier layer, a protective layer, and a buffer layer.

Examples of a material of the gas barrier layer include inorganic materials such as silicon nitride and silicon oxide.

The photoelectric conversion element of the present disclosure may have a series junction formed by stacking two or more photoelectric conversion layers (making as a tandem) via one or more intermediate electrodes. Examples of the laminate structure include a laminate structure including a substrate, a first electrode, a hole-transporting layer, a first photoelectric conversion layer, an intermediate electrode, a second photoelectric conversion layer, an electron-transporting layer, and a second electrode in this order. Use of the laminate can improve open-circuit voltage.

### <Use>

Recently, there is a need for, especially as an energy harvesting element, a photoelectric conversion element capable of efficiently generating electric power with very weak light. Typical examples of weak light include light from LED lamps, and light from a fluorescent lamps. The above-mentioned light is typically used indoor, and is called indoor light. The illuminance of the indoor light is from about 20 Lux through about 1,000 Lux, and the indoor light is very weak light compared to direct sunlight (about 100,000 Lux).

The photoelectric conversion element of the present disclosure exhibits high conversion efficiency with very weak light, such as the above-mentioned indoor light, and can be applied for a power supply by using in combination with a circuit board capable of controlling the generated electric current. Examples of a device utilizing the power supply include calculators, and watches. Other than the above-listed examples, a power supply containing the photoelectric conversion element of the present disclosure can be used in mobile phones, electric organizers, and electronic paper. Moreover, a power supply containing the photoelectric conversion element of the present disclosure can also be used as an auxiliary power for extending continuous usage of rechargeable or battery-driven electric appliances. Furthermore, the photoelectric conversion element of the present disclosure can be also applied as an image sensor.

One example of a layer structure of the photoelectric conversion element of the present disclosure is illustrated in FIG. 1. In the photoelectric conversion element of FIG. 1, a first electrode 2, an electron-transporting layer 3, a photoelectric conversion layer 4, a hole-transporting layer 5, and a second electrode 6 are disposed on a substrate 1 in the order as mentioned.

### Examples

The present disclosure will be described in more detail by way of the following Examples. However, the present disclosure should not be construed as being limited to these Examples.

### (Example 1)

### <Production of photoelectric conversion element>

### -Production of electron-transporting layer-

Zinc acetate (available from Sigma-Aldrich Co., LLC) in an amount of 1 g, 0.28 g of ethanolamine (available from Sigma-Aldrich Co., LLC), and 10 mL of methoxyethanol (available from Wako Pure Chemical Industries, Ltd.) were stirred overnight at room temperature (25°C) to thereby prepare a zinc oxide precursor solution. Next, the zinc oxide precursor solution was applied onto an ITO substrate (10 Ω/□) by spin coating in a manner that a film thickness was to be 20 nm, and the applied solution was dried for 10 minutes at 200°C, to thereby form an electron-transporting layer.

### -Production of photoelectric conversion layer-

In 1 mL of chloroform, 10 mg of Exemplary Compound 1, 2 mg of PC71BM (phenyl C71 methyl butyrate, available from Frontier Carbon Corporation), and 8 mg of PC61BM (phenyl C61 methyl butyrate, available from Frontier Carbon Corporation) were dissolved to prepare a photoelectric conversion layer solution. Onto the electron-transporting layer, the photoelectric conversion layer solution was applied by spin coating in a manner that a film thickness was to be 100 nm, to thereby form a photoelectric conversion layer.

### -Production of hole-transporting layer and metal electrode-

On the photoelectric conversion layer, molybdenum oxide (available from KOJUNDO CHEMICAL LABORATORY CO., LTD.) in the thickness of 10 nm, and silver in the thickness of 100 nm were sequentially formed by vacuum vapor deposition. In the manner as described, a photoelectric conversion element was produced.

### (Example 2)

### -Production of photoelectric conversion element-

A photoelectric conversion element was produced in the same manner as in Example 1, except that Exemplary Compound 1 in the photoelectric conversion layer solution was replaced with Exemplary Compound 14.

### (Example 3)

### -Production of photoelectric conversion element-

A photoelectric conversion element was produced in the same manner as in Example 1, except that Exemplary Compound 1 in the photoelectric conversion layer solution was replaced with Exemplary Compound 13.

### (Example 4)

### -Production of photoelectric conversion element-

A photoelectric conversion element was produced in the same manner as in Example 1, except that Exemplary Compound 1 in the photoelectric conversion layer solution was replaced with Exemplary Compound 6.

### (Example 5)

### -Production of photoelectric conversion element-

A photoelectric conversion element was produced in the same manner as in Example 1, except that Exemplary Compound 1 in the photoelectric conversion layer solution was replaced with Exemplary Compound 4.

### (Example 6)

### -Production of photoelectric conversion element-

A photoelectric conversion element was produced in the same manner as in Example 1, except that Exemplary Compound 1 in the photoelectric conversion layer solution was replaced with Exemplary Compound 9.

### (Example 7)

### -Production of photoelectric conversion element-

A photoelectric conversion element was produced in the same manner as in Example 1, except that Exemplary Compound 1 in the photoelectric conversion layer solution was replaced with Exemplary Compound 5.

### (Example 8)

### -Production of photoelectric conversion element-

A photoelectric conversion element was produced in the same manner as in Example 1, except that Exemplary Compound 1 in the photoelectric conversion layer solution was replaced with Exemplary Compound 10.

### (Example 9)

### -Production of photoelectric conversion element-

A photoelectric conversion element was produced in the same manner as in Example 1, except that Exemplary Compound 1 in the photoelectric conversion layer solution was replaced with Exemplary Compound 11.

### (Example 10)

### -Production of photoelectric conversion element-

A photoelectric conversion element was produced in the same manner as in Example 1, except that Exemplary Compound 1 in the photoelectric conversion layer solution was replaced with Exemplary Compound 15.

### (Example 11)

### -Production of photoelectric conversion element-

A photoelectric conversion element was produced in the same manner as in Example 1, except that the amount of PC71BM in the photoelectric conversion layer solution was changed to 0.5 mg and the amount of PC61BM in the photoelectric conversion layer solution was changed to 9.5 mg.

### (Example 12)

### -Production of photoelectric conversion element-

A photoelectric conversion element was produced in the same manner as in Example 1, except that the amount of PC71BM in the photoelectric conversion layer solution was changed to 1.0 mg and the amount of PC61BM in the photoelectric conversion layer solution was changed to 9.0 mg.

### (Example 13)

### -Production of photoelectric conversion element-

A photoelectric conversion element was produced in the same manner as in Example 1, except that the amount of PC71BM in the photoelectric conversion layer solution was changed to 2.5 mg and the amount of PC61BM in the photoelectric conversion layer solution was changed to 7.5 mg.

### (Example 14)

### -Production of photoelectric conversion element-

A photoelectric conversion element was produced in the same manner as in Example 1, except that the amount of PC71BM in the photoelectric conversion layer solution was changed to 3.0 mg and the amount of PC61BM in the photoelectric conversion layer solution was changed to 7.0 mg.

### (Example 15)

### -Production of photoelectric conversion element-

A photoelectric conversion element was produced in the same manner as in Example 1, except that the amount of PC71BM in the photoelectric conversion layer solution was changed to 0.3 mg and the amount of PC61BM in the photoelectric conversion layer solution was changed to 9.7 mg.

### (Comparative Example 1)

### -Production of photoelectric conversion element-

A photoelectric conversion element was produced in the same manner as in Example 1, except that Exemplary Compound 1 in the photoelectric conversion layer solution was changed to 12.5 mg of P3HT (available from Merck KGaA) represented by the following structural formula, and the solvent for use was changed from chloroform to chlorobenzene. After the production of the photoelectric conversion element, the photoelectric conversion element was heated in a glove box of argon atmosphere for 10 minutes at 150°C.

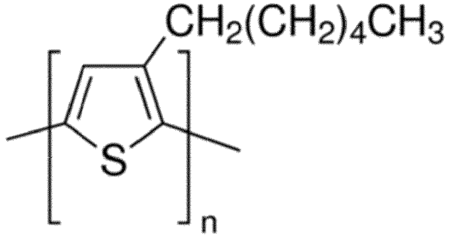

In the structural formula above, n is an integer of 1 or greater.

### (Comparative Example 2)

### -Production of photoelectric conversion element-

A photoelectric conversion element was produced in the same manner as in Example 1, except that Exemplary Compound 1 in the photoelectric conversion layer solution was changed to 7 mg of PTB7 (available from 1-Material) represented by the following structural formula, and the solvent for use was changed to chlorobenzene including 1 vol% of 1,8-diiodooctane.

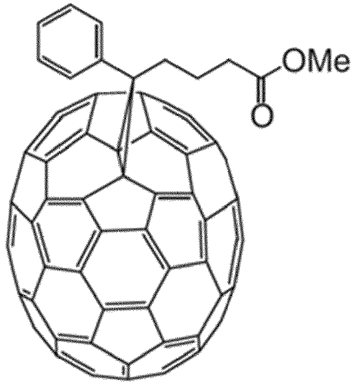

In the structural formula above, Me is a methyl group.

### (Comparative Example 3)

### -Production of photoelectric conversion element-

A photoelectric conversion element was produced in the same manner as in Example 1, except that the amount of PC71BM in the photoelectric conversion layer solution was changed to 10 mg and PC61BM was not added to the photoelectric conversion layer solution.

### (Comparative Example 4)

### -Production of photoelectric conversion element-

A photoelectric conversion element was produced in the same manner as in Example 1, except that the amount of PC61BM in the photoelectric conversion layer solution was changed to 10 mg and PC71BM was not added to the photoelectric conversion layer solution.

### (Comparative Example 5)

### -Production of photoelectric conversion element-

A photoelectric conversion element was produced in the same manner as in Example 1, except that the amount of PC71BM in the photoelectric conversion layer solution was changed to 5 mg and the amount of PC61BM in the photoelectric conversion layer solution was changed to 5 mg.

### (Comparative Example 6)

### -Production of photoelectric conversion element-

A photoelectric conversion element was produced in the same manner as in Example 1, except that the amount of PC71BM in the photoelectric conversion layer solution was changed to 4.0 mg and the amount of PC61BM in the photoelectric conversion layer solution was changed to 6.0 mg.

### <Measurement of maximum output>

Next, the maximum output of each of the photoelectric conversion elements produced in Examples 1 to 15 and Comparative Examples 1 to 6 under white LED radiation (200 Lux, 70 µW/cm²) was measured. Note that, the maximum output of Comparative Example 1 was determined as 1.

The maximum output of each of the photoelectric conversion elements of Examples 1 to 15 and Comparative Examples 2 to 6 was presented as relative output relative to 1 that was the maximum output of Comparative Example 1. Note that, a desk lamp CDS-90α available from Cosmotechno Co., Ltd. was used as the white LED, and the output was measured by a solar battery evaluation system As-510-PV03 available from NF Corporation.

**Table 1**

| | Relative output (when Comp. Ex. 1 was determined as 1) |
|---|---|
| Ex. 1 | 2.7 |
| Ex. 2 | 2.8 |
| Ex. 3 | 3.4 |
| Ex. 4 | 3.3 |
| Ex. 5 | 3.7 |
| Ex. 6 | 3.6 |
| Ex. 7 | 3.5 |
| Ex. 8 | 3.4 |
| Ex. 9 | 3.2 |
| Ex. 10 | 3.2 |
| Ex. 11 | 3.4 |
| Ex. 12 | 3.5 |
| Ex. 13 | 3.5 |
| Ex. 14 | 3.4 |
| Ex. 15 | 2.3 |
| Comp. Ex. 1 | 1 |
| Comp. Ex. 2 | 1.5 |
| Comp. Ex. 3 | 2.3 |
| Comp. Ex. 4 | 2.1 |
| Comp. Ex. 5 | 2.2 |
| Comp. Ex. 6 | 2.2 |

It was found from the results of Table 1 that the photoelectric conversion elements of Examples 1 to 15 had high conversion efficiency with very weak light under white LED radiation (70 uW/cm²) and were excellent compared to the photoelectric conversion elements of Comparative Examples 1 to 6.

## Claims

1. A photoelectric conversion element comprising:
a first electrode (2);
an electron-transporting layer (3);
a photoelectric conversion layer (4);
a hole-transporting layer (5); and
a second electrode (6), where the electron-transporting layer, the photoelectric conversion layer, the hole-transporting layer, and the second electrode are sequentially disposed on the first electrode,
wherein the photoelectric conversion layer includes a mixture of a P-type material and an N-type material,
the P-type material is a compound represented by General Formula 1 below,
the N-type material includes a mixture of C70 Fullerene Derivative A having a substituent represented by General Formula 2 below and C60 Fullerene Derivative B having a substituent identical to the substituent of C70 Fullerene Derivative A, and a mixing mass ratio (A:B) of C70 Fullerene Derivative A to C60 Fullerene Derivative B is from 5:95 through 30:70, 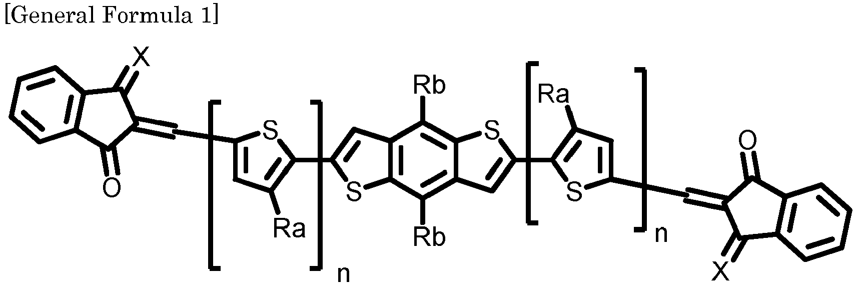
where, in General Formula 1, n is an integer of from 1 through 3, Ra is an alkyl group having 4 through 12 carbon atoms, Rb is an oxygen atom including an alkyl group having 6 through 22 carbon atoms, a sulfur atom including an alkyl group having 6 through 22 carbon atoms, a carbon atom including an alkyl group having 6 through 22 carbon atoms, or
a group represented by General Formula 5 below, and X is an oxygen atom or a dicyanomethylene group, 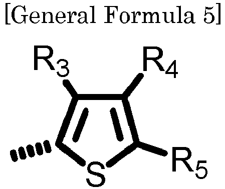
where, in General Formula 5, R₃ and R₄ are each a hydrogen atom or an alkyl group having 6 through 12 carbon atoms, and R₅ is an alkyl group that has 6 through 22 carbon atoms and may be branched, 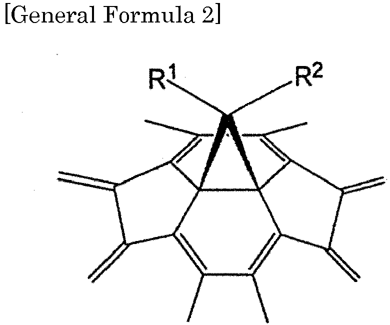
where General Formula 2 represents a partial structure of a fullerene skeleton, and in General Formula 2, R¹ and R² are each independently an alkyl group, an alkyl group having a substituent, an aryl group, an aryl group having a substituent, or an alkoxycarbonyl group.

2. The photoelectric conversion element according to claim 1,
wherein the compound represented by General Formula 1 is a compound represented by General Formula 3 below; 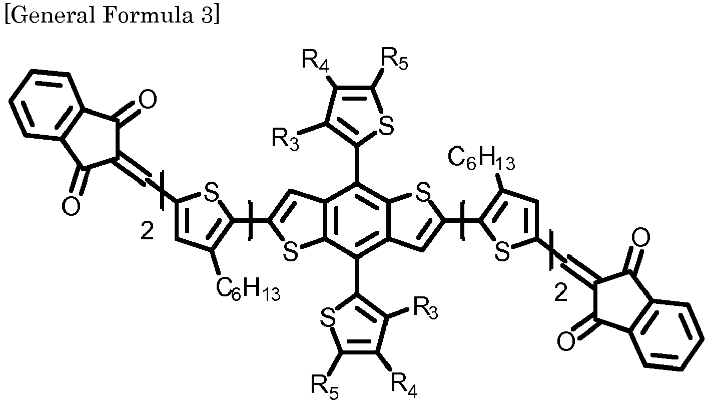 where, in General Formula 3, R₃ and R₄ are each a hydrogen atom or an alkyl group having 6 through 12 carbon atoms, and R₅ is an alkyl group that has 6 through 22 carbon atoms and may be branched.

3. The photoelectric conversion element according to claim 1,
wherein the compound represented by General Formula 1 is a compound represented by General Formula 4 below: 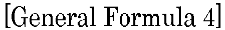 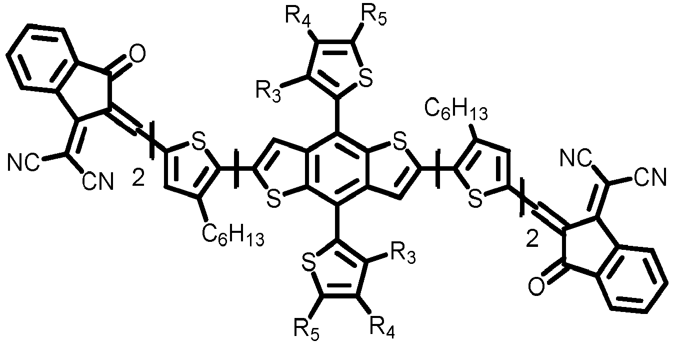 where in General Formula 4, R₃ and R₄ are each a hydrogen atom or an alkyl group having 6 through 12 carbon atoms, and R₅ is an alkyl group that has 6 through 22 carbon atoms and may be branched.

4. The photoelectric conversion element according to claim 2,
wherein the compound represented by General Formula 3 is a compound represented by General Formula 6 below: 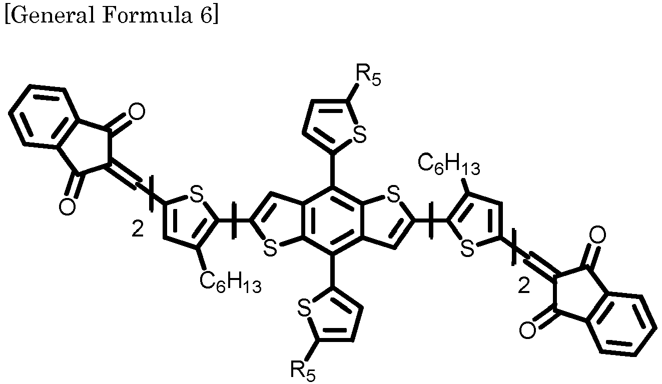 where, in General Formula 6, R₅ is an alkyl group that has 6 through 22 carbon atoms and may be branched.

5. The photoelectric conversion element according to claim 3,
wherein the compound represented by General Formula 4 is a compound represented by General Formula 7 below: 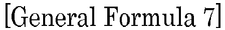 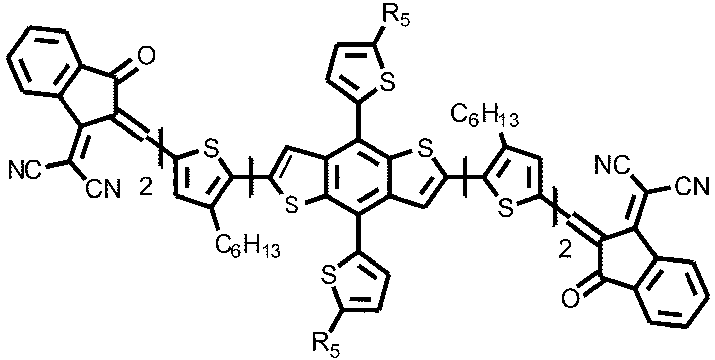 where, in General Formula 7, R₅ is an alkyl group that has 6 through 22 carbon atoms and may be branched.

6. The photoelectric conversion element according to any one of claims 1 to 5, wherein a mixing mass ratio (P:N) of the P-type material to the N-type material is from 35:65 through 80:20.

## Patentansprüche

1. Element zur fotoelektrischen Umwandlung, umfassend:
eine erste Elektrode (2);
eine elektronentransportierende Schicht (3);
eine fotoelektrische Umwandlungsschicht (4);
eine lochtransportierende Schicht (5); und
eine zweite Elektrode (6),
wobei die elektronentransportierende Schicht, die fotoelektrische Umwandlungsschicht, die lochtransportierende Schicht und die zweite Elektrode sequenziell an der ersten Elektrode angeordnet sind,
wobei die fotoelektrische Umwandlungsschicht ein Gemisch aus einem P-Typ-Material und einem N-Typ-Material einschließt,
das P-Typ-Material eine Verbindung ist, dargestellt durch die nachstehende allgemeine Formel 1,
das N-Typ-Material ein Gemisch aus C70 Fullerenderivat A einschließt, welches einen Substituenten aufweist, welcher durch die nachstehende allgemeine Formel 2 dargestellt wird, und C60 Fullerenderivat B, welches einen mit dem Substituenten von C70 Fullerenderivat A identischen Substituenten aufweist, und wobei ein Massenmischungsverhältnis (A:B) zwischen C70 Fullerenderivat A und C60 Fullerenderivat B 5:95 bis 30:70 beträgt, 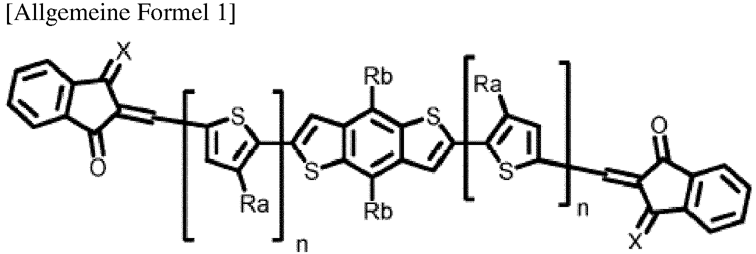
wobei, in der allgemeinen Formel 1, n eine Ganzzahl von 1 bis 3 ist, Ra eine Alkylgruppe ist, die 4 bis 12 Kohlenstoffatome aufweist, Rb ein Sauerstoffatom ist, einschließend eine Alkylgruppe, die 6 bis 22 Kohlenstoffatome aufweist, ein Schwefelatom, einschließend eine Alkylgruppe, die 6 bis 22 Kohlenstoffatome aufweist, ein Kohlenstoffatom, einschließend eine Alkylgruppe, die 6 bis 22 Kohlenstoffatome aufweist, oder eine Gruppe, dargestellt durch die nachstehende allgemeine Formel 5, und X ein Sauerstoffatom oder eine Dicyanomethylengruppe ist, 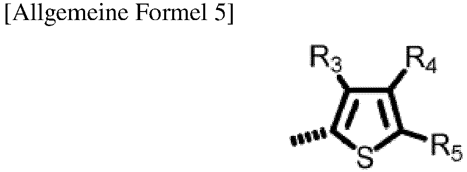
wobei, in der allgemeinen Formel 5, R₃ und R₄ jeweils ein Wasserstoffatom oder eine Alkylgruppe, die 6 bis 12 Kohlenstoffatome aufweist, sind, und R₅ eine Alkylgruppe ist, die 6 bis 22 Kohlenstoffatome aufweist und verzweigt sein kann, 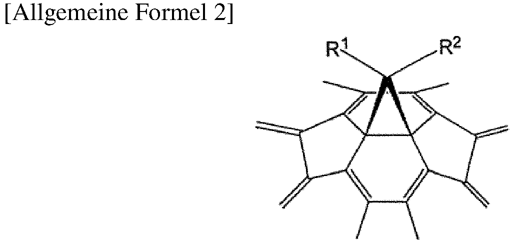
wobei die allgemeine Formel 2 eine Teilstruktur eines Fulleren-Skeletts darstellt, und in der allgemeinen Formel 2, R¹ und R² jeweils unabhängig eine Alkylgruppe, eine Alkylgruppe, die einen Substituenten aufweist, eine Arylgruppe, eine Arylgruppe, die einen Substituenten aufweist oder eine Alkoxycarbonylgruppe sind.

2. Element zur fotoelektrischen Umwandlung nach Anspruch 1,
wobei die durch die allgemeine Formel 1 dargestellte Verbindung eine Verbindung ist, dargestellt durch die nachstehende allgemeine Formel 3; 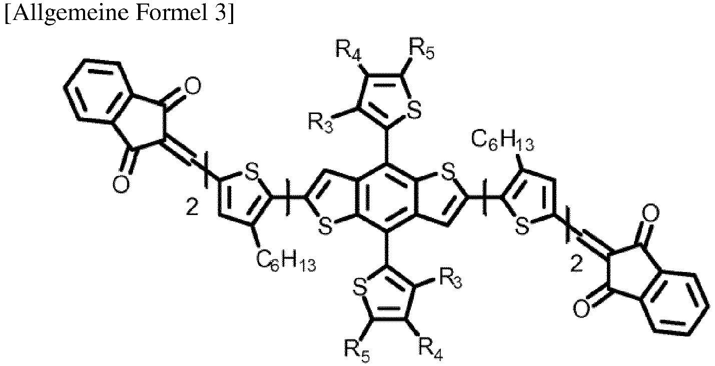 wobei, in der allgemeinen Formel 3, R₃ und R₄ jeweils ein Wasserstoffatom oder eine Alkylgruppe ist, die 6 bis 12 Kohlenstoffatome aufweist, und R₅ eine Alkylgruppe ist, die 6 bis 22 Kohlenstoffatome aufweist und verzweigt sein kann.

3. Element zur fotoelektrischen Umwandlung nach Anspruch 1,
wobei die durch die allgemeine Formel 1 dargestellte Verbindung eine Verbindung ist, dargestellt durch die nachstehende allgemeine Formel 4: 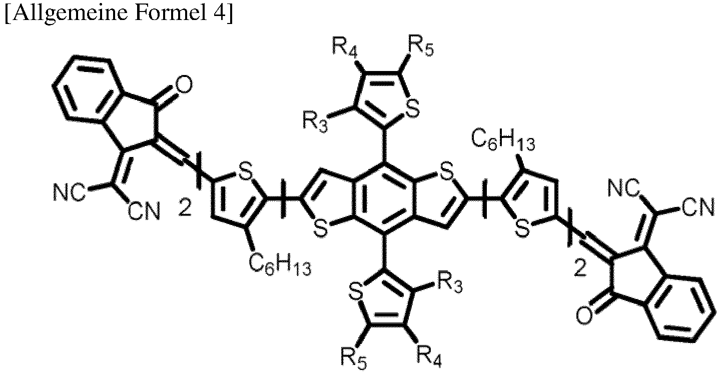 wobei, in der allgemeinen Formel 4, R₃ und R₄ jeweils ein Wasserstoffatom oder eine Alkylgruppe ist, die 6 bis 12 Kohlenstoffatome aufweist, und R₅ eine Alkylgruppe ist, die 6 bis 22 Kohlenstoffatome aufweist und verzweigt sein kann.

4. Element zur fotoelektrischen Umwandlung nach Anspruch 2,
wobei die durch die allgemeine Formel 3 dargestellte Verbindung eine Verbindung ist, dargestellt durch die nachstehende allgemeine Formel 6: 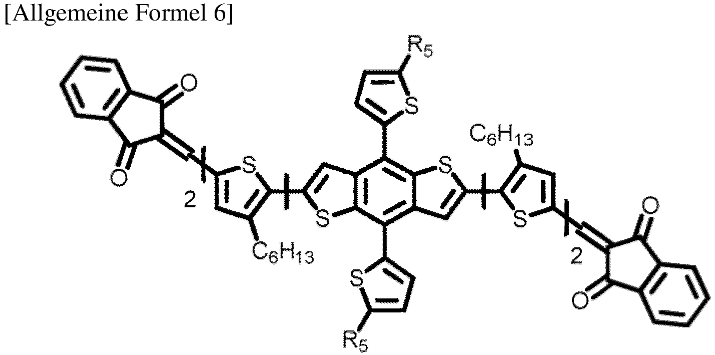 wobei, in der allgemeinen Formel 6, R₅ eine Alkylgruppe ist, die 6 bis 22 Kohlenstoffatome aufweist und verzweigt sein kann.

5. Element zur fotoelektrischen Umwandlung nach Anspruch 3,
wobei die durch die allgemeine Formel 4 dargestellte Verbindung eine Verbindung ist, dargestellt durch die nachstehende allgemeine Formel 7: 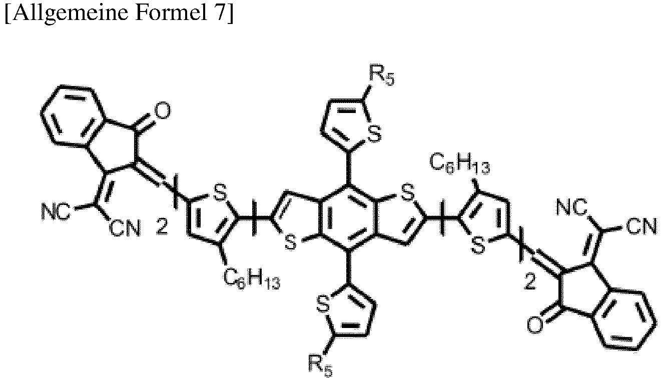 wobei, in der allgemeinen Formel 7, R₅ eine Alkylgruppe ist, die 6 bis 22 Kohlenstoffatome aufweist und verzweigt sein kann.

6. Element zur fotoelektrischen Umwandlung nach einem der Ansprüche 1 bis 5,
wobei ein Massenmischungsverhältnis (P:N) zwischen dem P-Typ-Material und dem N-Typ-Material 35:65 bis 80:20 beträgt.

## Revendications

1. Élément de conversion photoélectrique comprenant :
une première électrode (2) ;
une couche de transport d'électrons (3) ;
une couche de conversion photoélectrique (4) ;
une couche de transport de trous (5) ; et
une seconde électrode (6) ;
dans lequel la couche de transport d'électrons, la couche de conversion photoélectrique, la couche de transport de trous et la seconde électrode sont disposées de façon séquentielle sur la première électrode ;
dans lequel la couche de conversion photoélectrique inclut un mélange d'un matériau de type P et d'un matériau de type N ;
le matériau de type P est un composé qui est représenté par la formule générale 1 ci-dessous ;
le matériau de type N inclut un mélange d'un dérivé de fullerène C70 A qui comporte un substituant qui est représenté par la formule générale 2 ci-dessous et d'un dérivé de fullerène C60 B qui comporte un substituant qui est identique au substituant du dérivé de fullerène C70 A, et dans lequel un rapport de masses de mélange (A:B) du dérivé de fullerène C70 A sur le dérivé de fullerène C60 B va de 5:95 à 30:70 ; 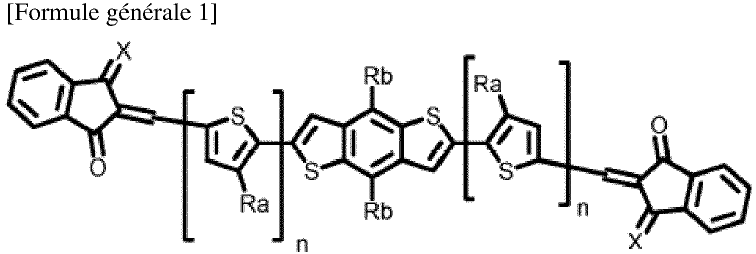
dans lequel, dans la formule générale 1, n est un entier de 1 à 3, Ra est un groupe alkyle qui comporte de 4 à 12 atomes de carbone, Rb est un atome d'oxygène qui inclut un groupe alkyle qui comporte de 6 à 22 atomes de carbone, un atome de soufre qui inclut un groupe alkyle qui comporte de 6 à 22 atomes de carbone, un atome de carbone qui inclut un groupe alkyle qui comporte de 6 à 22 atomes de carbone ou un groupe qui est représenté par la formule générale 5 ci-dessous, et X est un atome d'oxygène ou un groupe dicyanométhylène ; 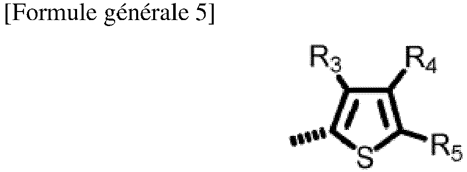
dans lequel, dans la formule générale 5, R₃ et R₄ sont chacun un atome d'hydrogène ou un groupe alkyle qui comporte de 6 à 12 atomes de carbone, et R₅ est un groupe alkyle qui comporte de 6 à 22 atomes de carbone et qui peut être ramifié ; 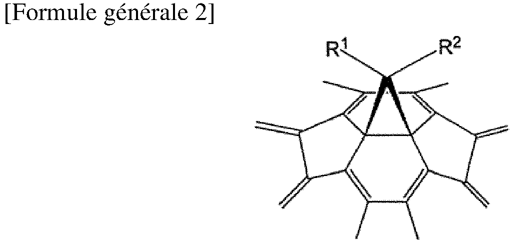
dans lequel la formule générale 2 représente une structure partielle d'un squelette de fullerène et dans la formule générale 2, R¹ et R² sont chacun de manière indépendante un groupe alkyle, un groupe alkyle qui comporte un substituant, un groupe aryle, un groupe aryle qui comporte un substituant ou un groupe alcoxycarbonyle.

2. Élément de conversion photoélectrique selon la revendication 1,
dans lequel le composé qui est représenté par la formule générale 1 est un composé qui est représenté par la formule générale 3 ci-dessous : 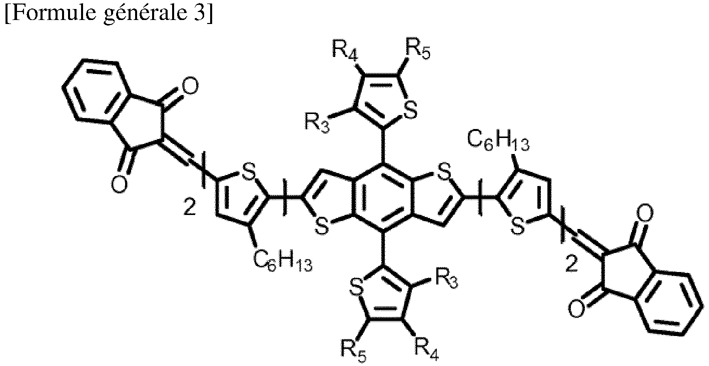 dans lequel, dans la formule générale 3, R₃ et R₄ sont chacun un atome d'hydrogène ou un groupe alkyle qui comporte de 6 à 12 atomes de carbone et R₅ est un groupe alkyle qui comporte de 6 à 22 atomes de carbone et qui peut être ramifié.

3. Élément de conversion photoélectrique selon la revendication 1,
dans lequel le composé qui est représenté par la formule générale 1 est un composé qui est représenté par la formule générale 4 ci-dessous : 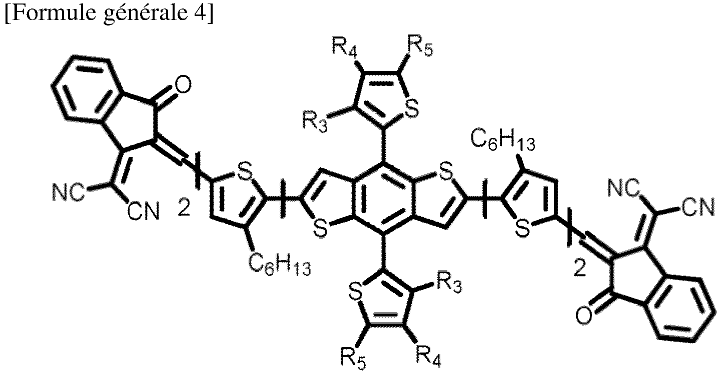 dans lequel, dans la formule générale 4, R₃ et R₄ sont chacun un atome d'hydrogène ou un groupe alkyle qui comporte de 6 à 12 atomes de carbone et R₅ est un groupe alkyle qui comporte de 6 à 22 atomes de carbone et qui peut être ramifié.

4. Élément de conversion photoélectrique selon la revendication 2,
dans lequel le composé qui est représenté par la formule générale 3 est un composé qui est représenté par la formule générale 6 ci-dessous : 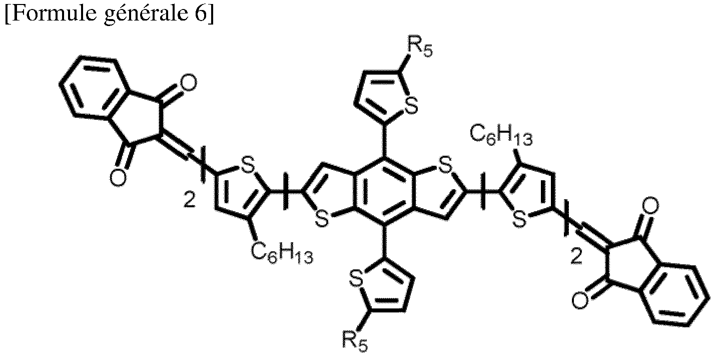 dans lequel, dans la formule générale 6, R₅ est un groupe alkyle qui comporte de 6 à 22 atomes de carbone et qui peut être ramifié.

5. Élément de conversion photoélectrique selon la revendication 3,
dans lequel le composé qui est représenté par la formule générale 4 est un composé qui est représenté par la formule générale 7 ci-dessous : 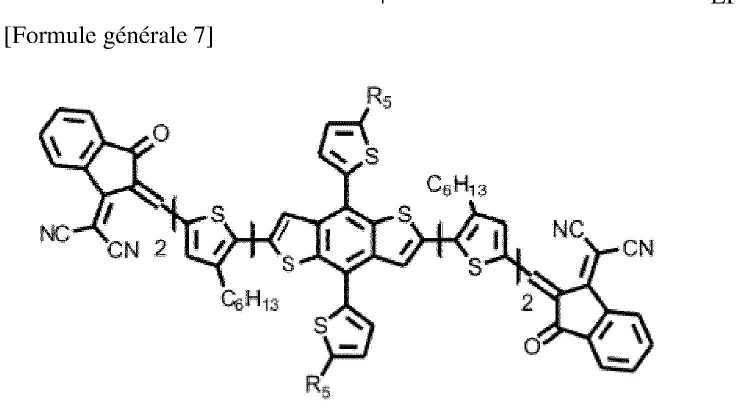 dans lequel, dans la formule générale 7, R₅ est un groupe alkyle qui comporte de 6 à 22 atomes de carbone et qui peut être ramifié.

6. Élément de conversion photoélectrique selon l'une quelconque des revendications 1 à 5,
dans lequel un rapport de masses de mélange (P:N) du matériau de type P sur le matériau de type N va de 35:65 à 80:20.
